# DEMANDE DE BREVET EUROPEEN

(11) **EP 0 996 146 A1**
(43) Date de publication de la demande: **26.04.2000**
(21) Numéro de dépôt: 99410143.4
(22) Date de dépôt: 22.10.1999
(51) Int. Cl.: H01L 21/20, H01L 21/762, H01L 27/06, H01L 29/06

(54) **Procédé de formation d'un caisson isolé dans une plaquette de silicium**

(30) Priorité: 23.10.1998 FR 9813541
(71) Demandeur: STMicroelectronics SA, 94250 Gentilly Cedex (FR)
(72) Inventeur: Anceau, Christine, 37390 Saint Roch (FR)
(74) Mandataire: de Beaumont, Michel

(57) **Abrégé**

L'invention concerne un procédé de formation d'un caisson isolé dans une portion supérieure d'un substrat de silicium, comprenant les étapes consistant à prévoir une structure de type silicium sur isolant comprenant un substrat de silicium (10), une couche isolante et une couche mince de silicium mono-cristallin ; éliminer la couche isolante et la couche mince de silicium en dehors des emplacements où l'on veut former le caisson isolé ; faire croître une couche épitaxiée (24, 25) ; effectuer une planarisation ; et réaliser un mur d'isolement vertical (29) à l'aplomb de la périphérie de la portion maintenue (21) de la couche mince isolante.

## Description

La présente invention concerne la fabrication de puces semiconductrices comportant au moins une zone correspondant à des composants de puissance et au moins une zone correspondant à des composants logiques.

Depuis très longtemps, les concepteurs et fabricants de composants semiconducteurs ont cherché à intégrer sur une même puce des circuits logiques et au moins un composant de puissance vertical dont une première électrode se trouve sur la face supérieure et une deuxième électrode sur la face inférieure de la puce. On se heurte alors au problème de l'isolement des circuits logiques alimentés par de faibles tensions et dans lesquels passent de faibles courants, qui sont susceptibles d'être perturbés par les tensions et les courants importants dans les composants de puissance. Les solutions classiques, qui consistent à utiliser des isolements par jonction, ne sont jamais totalement efficaces. On a donc pensé à former les circuits logiques dans une partie isolée diélectriquement par rapport au substrat dans lequel sont réalisés les composants de puissance. Un exemple d'une telle solution a été décrit en 1985 par Joseph Borel dans le brevet européen 0220974. Toutefois, bien que séduisantes théoriquement, les diverses structures proposées ont présenté des difficultés de réalisation qui ont conduit à ce que, en pratique, il n'existe pas aujourd'hui sur le marché de composants de puissance associés à des circuits logiques à isolement diélectrique complet ou partiel par rapport à la partie de puissance.

C'est un objet de la présente invention que de proposer une solution à ce problème qui satisfasse notamment aux critères suivants :
- il n'existe pas d'interface perturbée dans la zone verticale correspondant aux composants de puissance ; et
- la surface apparente de la partie de la puce destinée à la réalisation des circuits logiques est au même niveau que la surface supérieure de la puce destinée à la réalisation d'un composant de puissance.

Ce deuxième critère est d'une grande importance pratique. En effet, réaliser des opérations de photolithographie sur des surfaces situées dans des plans distincts complexifie les procédés de fabrication.

Pour atteindre cet objet, la présente invention prévoit un procédé de formation d'un caisson isolé dans une portion supérieure d'un substrat de silicium, comprenant les étapes consistant à prévoir une structure de type silicium sur isolant comprenant un substrat de silicium, une couche isolante et une couche mince de silicium monocristallin ; éliminer la couche isolante et la couche mince de silicium en dehors des emplacements où l'on veut former le caisson isolé ; faire croître une couche épitaxiée ; effectuer une planarisation ; et réaliser un mur d'isolement vertical à l'aplomb de la périphérie de la portion maintenue de la couche mince isolante.

Selon un mode de réalisation de la présente invention, la couche épitaxiée a une épaisseur supérieure à 10 µm.

Selon un mode de réalisation de la présente invention, l'épaisseur de la couche épitaxiée est de l'ordre de 40 à 60 µm.

Selon un mode de réalisation de la présente invention, l'étape de gravure de la couche mince de silicium monocristallin et de la couche isolante comprend les étapes consistant à former une couche d'un premier matériau gravable sélectivement par rapport au silicium ; déposer et délimiter un masque de résine photosensible ; graver la couche du premier matériau et la couche mince de silicium ; déposer une nouvelle couche de résine présentant un débordement par rapport aux couches déjà gravées ; graver la couche isolante sous la nouvelle couche de résine ; éliminer la couche de résine et la partie supérieure restante de la couche du premier matériau.

Selon un mode de réalisation de la présente invention, la couche isolante et la couche du premier matériau sont des couches d'oxyde de silicium.

Selon un mode de réalisation de la présente invention, la formation du mur d'isolement vertical comprend les étapes consistant à former une couche d'un deuxième matériau d'une première épaisseur ; former dans la couche du deuxième matériau une première ouverture à l'emplacement du mur que l'on souhaite former ; former une couche d'un troisième matériau d'une deuxième épaisseur ; graver la couche du deuxième matériau sensiblement au milieu de la première ouverture ; ouvrir le silicium sous-jacent jusqu'à la couche d'oxyde d'isolement de fond ; procéder à la formation d'un isolement sur les parois de l'ouverture ; procéder à un remplissage de silicium polycristallin.

Selon un mode de réalisation de la présente invention, les deuxième et troisième matériaux sont de l'oxyde de silicium et la deuxième épaisseur est inférieure à la première épaisseur.

Selon un mode de réalisation de la présente invention, la couche mince de silicium monocristallin est fortement dopée d'un type de conductivité choisi, la couche épitaxiée étant du même type de conductivité à faible niveau de dopage.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure que la présente invention vise à obtenir ;
les figure 2A à 2D sont des vues en coupe illustrant des étapes générales du procédé de fabrication selon la présente invention ;
les figures 3A à 3K représentent de façon plus détaillée des étapes du procédé de fabrication selon la présente invention ; et
les figures 4 à 6 représentent un exemple de structure compatible avec le procédé selon la présente invention.

On notera que, comme cela est usuel dans le domaine de la représentation des composants semiconducteurs, les diverses vues en coupe ne sont pas représentées à l'échelle ni pour une figure donnée ni d'une figure à l'autre. Pour les dimensions réelles des divers composants, on se référera aux connaissances générales de l'homme de métier ou le cas échéant aux indications données dans la présente description.

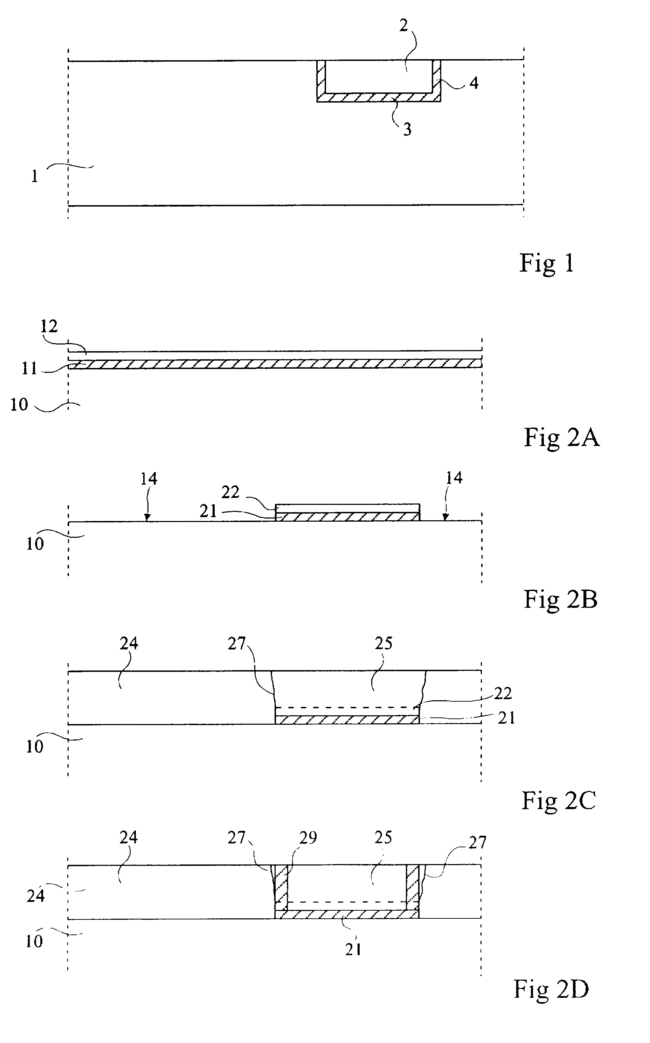

La figure 1 est une vue en coupe de la structure semiconductrice que vise à fabriquer la présente invention. Essentiellement, la présente invention vise à former une plaquette semiconductrice 1 comportant une région semiconductrice 2 isolée du reste de la plaquette 1 par un isolement diélectrique de fond 3 et par un isolement latéral 4, de préférence diélectrique mais éventuellement par jonction. En dehors de la région verticale correspondant à la zone à isolement diélectrique 2, le substrat ne doit pas présenter de zones défectueuses entre ses faces supérieure et inférieure. En outre, on cherche à obtenir une structure dans laquelle la surface supérieure du substrat 1 soit au même niveau que la surface supérieure de la région isolée 2.

Les grandes lignes du procédé selon la présente invention vont d'abord être décrites très schématiquement en relation avec les figures 2A à 2D.

Selon la présente invention, on part d'une structure telle qu'illustrée en figure 2A comprenant un substrat de silicium 10 revêtu d'une couche d'oxyde de silicium 11 elle-même revêtue d'une couche mince de silicium monocristallin 12. De telles structures, dites SOI (silicium sur isolant), se sont développées ces dernières années pour la fabrication de circuits intégrés rapides et protégés vis-à-vis des radiations. Etant donné la demande croissante de telles structures, leur prix est maintenant tout à fait accessible et il existe diverses techniques de fabrication pour les obtenir. On notera essentiellement que dans ces structures le substrat de silicium monocristallin 10 est de bonne qualité cristallographique de même que la couche mince de silicium 12 et que les perturbations, s'il y en a, sont regroupées au niveau de la couche isolante 11. On trouve par exemple actuellement commercialement des structures dans laquelle la couche d'oxyde de silicium a une épaisseur de 0,2 à 3 µm et la couche de silicium monocristallin une épaisseur de 0,1 à 1,5 µm.

Dans une première étape du procédé selon la présente invention dont le résultat est illustré en figure 2B, une partie de la couche mince de silicium monocristallin 12 et de la couche sous-jacente d'oxyde de silicium 11 est éliminée jusqu'à la face supérieure 14 du substrat de silicium monocristallin 10. On laisse en place une partie 21 de la couche isolante 11 surmontée d'une partie 22 de la couche de silicium 12 seulement aux emplacements où l'on veut former des caissons de silicium isolés.

Après cela, on procède à une étape de croissance épitaxiale de silicium sur la structure. Il se développe ainsi une couche de silicium monocristallin 24 de même orientation cristallographique que le substrat 10 au-dessus de la face apparente 14 du substrat et une couche de silicium monocristallin 25 de même orientation cristallographique que la couche mince de silicium 22 au-dessus que cette couche 22. Il existera une zone cristallographiquement perturbée (joint de grain) 27 seulement à l'interface entre les couches 24 et 25. La figure 2C représente la structure après que la face supérieure de la structure ait fait l'objet d'un traitement de planarisation, par exemple par polissage mécanochimique. En effet, lors de la croissance, la face supérieure de la couche 25 sera généralement plus haute que la face supérieure de la couche 24.

Dans une dernière étape dont le résultat est illustré en figure 2D, on forme des murs d'isolement verticaux 29, de préférence en un matériau isolant, qui viennent rejoindre la portion de couche isolante inférieure 21 pour enfermer complètement la région épitaxiée 24. Comme le montre la figure 2D, la surface supérieure de la région 25 est au même niveau que la surface supérieure de la région 24 en raison de l'étape de planarisation décrite en relation avec la figure 2C. D'autre part, l'épaisseur des couches épitaxiées 24, 25 peut être relativement importante, par exemple de 10 à 100 µm.

Comme on le verra ci-après, le substrat 10 peut être un substrat à dopage homogène ou un substrat comportant une partie supérieure et/ou inférieure à niveau de dopage plus élevé que sa partie médiane. Selon les applications visées, la couche 24 peut être du même type de conductivité que celui du substrat ou du type de conductivité opposé. De même, son niveau de dopage sera choisi en fonction des composants à former.

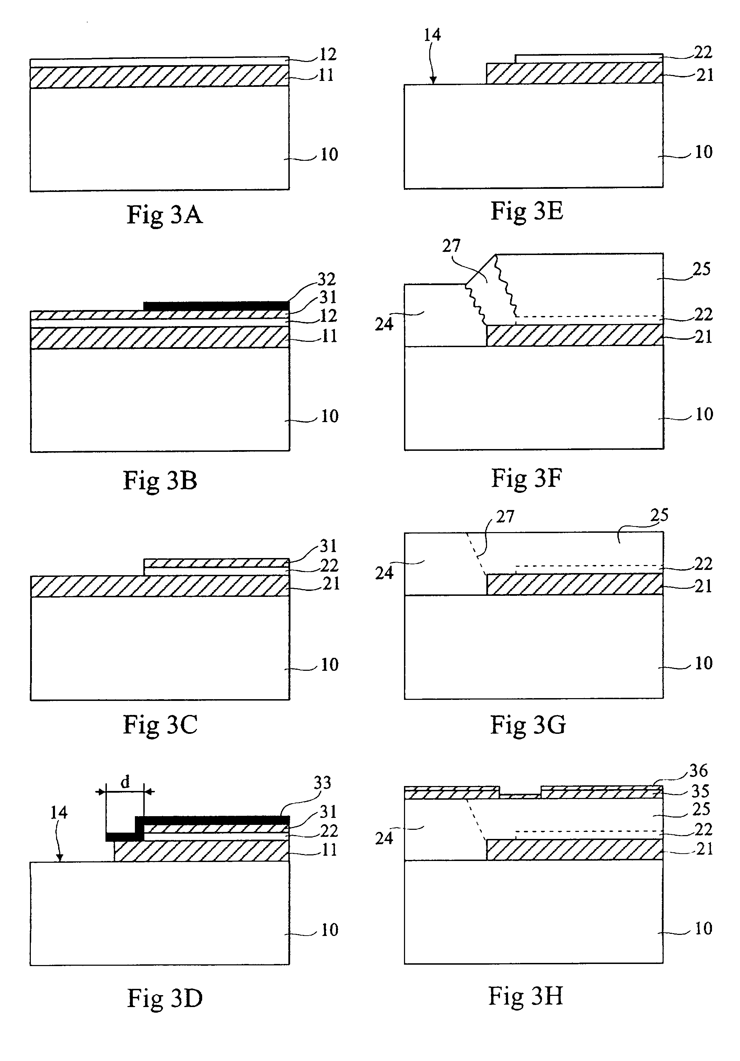

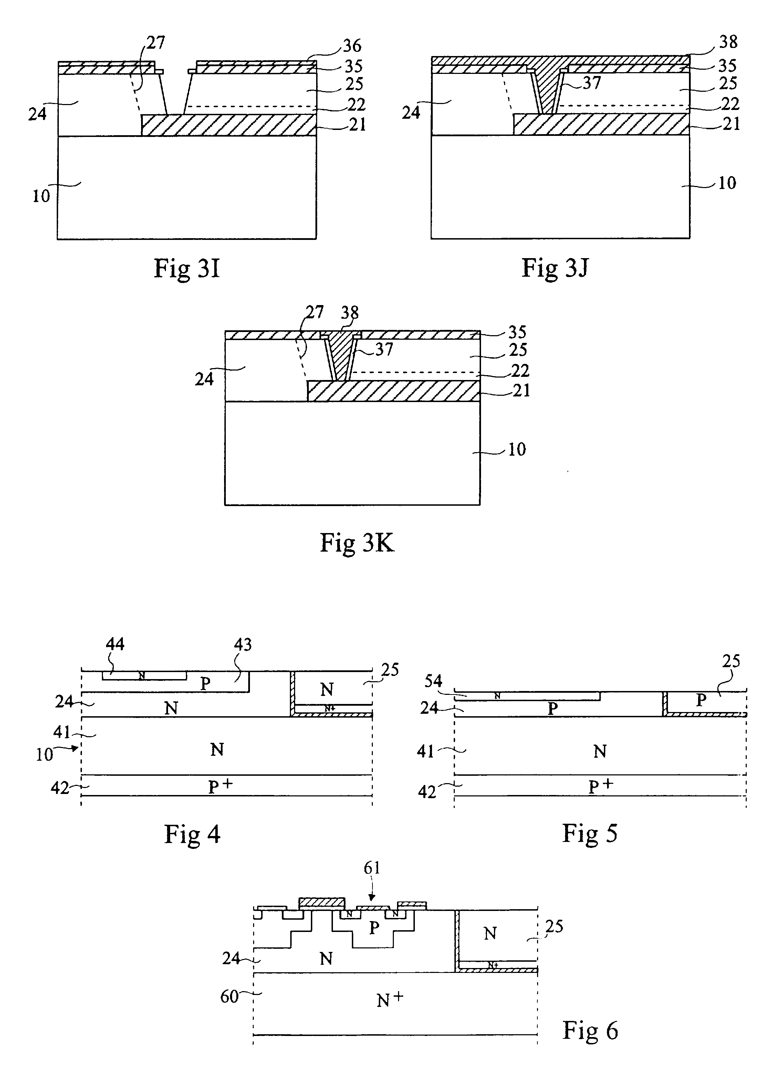

Un exemple de réalisation détaillé du procédé selon la présente invention va être décrit en relation avec les figures 3A à 3K. Dans ces figures, on a utilisé de mêmes références qu'en figures 2A à 2D pour désigner des éléments similaires. Un objet particulier de ce mode de réalisation est d'éviter toute perturbation de la qualité cristallographique de la structure aux emplacements où l'on souhaite réaliser des composants semiconducteurs de puissance verticaux.

La figure 3A, comme la figure 2A, représente une plaquette de silicium 10 revêtue d'une couche d'oxyde de silicium 11 elle-même revêtue d'une couche mince de silicium monocristallin 12. Le rôle essentiel de la couche de silicium monocristallin 12 étant de servir de base à la croissance d'une couche épitaxiale, son épaisseur sera choisie la plus fine possible afin de minimiser la différence de hauteur de marche après épitaxie entre les zones 24 et 25 (voir figure 2C) tout en étant compatible avec une oxydation mince de 20 à 30 nm. Son dopage pourra être d'un type et/ou d'un niveau différents de ceux de l'épitaxie ultérieure selon les besoins dans la zone isolée. On choisira par exemple une structure dans laquelle la couche de silicium monocristallin 12 a une épaisseur inférieure à 1 µm.

Les étapes décrites en relation avec les figures 3B à 3E correspondent à l'étape décrite en relation avec la figure 2B.

A l'étape illustrée en figure 3B, on revêt la structure d'une couche mince uniforme d'oxyde de silicium 31 d'une épaisseur de 20 à 30 nm après quoi on dépose une couche de résine 32 qui est éliminée aux emplacements où l'on veut dénuder le substrat.

A l'étape illustrée en figure 3C, on a procédé à une gravure successive de la couche d'oxyde 31 et de la couche mince de silicium monocristallin 12 et la résine 32 est enlevée. L'oxyde mince 31 est gravé par gravure sèche ou humide et le silicium 12 est gravé par gravure sèche selon les technologies classiques pour cette gamme d'épaisseur. La portion restante de la couche 12 est désignée par la référence 22.

A l'étape illustrée en figure 3D, on a revêtu la structure d'une couche de résine 33 qui a été ouverte sensiblement aux emplacements où on souhaite dénuder le substrat 10. La gravure de la couche de résine 33 est effectuée pour assurer que l'on a un certain débordement d de cette couche de résine par rapport aux parties restantes 22 de la couche de silicium monocristallin précédemment gravée. Ceci a essentiellement pour but d'éviter l'apparition d'une casquette de la couche de silicium monocristallin 22 au-dessus de la zone de puissance. La distance d est aussi faible que cela est possible avec les équipements d'alignement utilisés et en tenant compte de la surgravure du procédé de gravure de la couche 11. La couche d'oxyde 11, dont les parties restantes sont désignées par la référence 21, est gravée en gravure humide pour ne pas dégrader la surface apparente 14 du substrat de silicium 10.

A l'étape illustrée en figure 3E, on a éliminé la couche de résine 33 et la couche mince d'oxyde 31 pour obtenir la portion de couche d'oxyde de silicium 21 et la portion de couche de silicium monocristallin 22 telles que décrites en relation avec la figure 2B.

Un avantage du procédé décrit est que, à aucun moment, pendant une phase de gravure, une couche de résine ne se trouve directement en contact avec une couche de silicium monocristallin. En effet, il est connu qu'un tel contact risque, lors des opérations de gravure, de générer des polluants pouvant s'accrocher à la surface libre du silicium. Or, on souhaite que la surface libre du silicium soit de particulièrement bonne qualité pour permettre la réalisation d'une couche épitaxiale satisfaisante.

Les étapes décrites en relation avec les figures 3F et 3G correspondent à l'étape décrite en relation avec la figure 2C.

A l'étape illustrée en figure 3F, on a représenté le résultat de la croissance d'une couche épitaxiale d'une épaisseur supérieure à 10 µm. On obtiendra ainsi des régions épitaxiales monocristallines 24 et 25 séparées par une zone de joints de grain 27 à l'emplacement où les épitaxies se rejoignent. Par rapport à un plan 100, les bords des ouvertures sont orientés selon la direction <010>. On procède ensuite à une planarisation par polissage mécanochimique dont le résultat est illustré en figure 3G.

Les étapes illustrées en figure 3H à 3K illustrent un mode de réalisation de la formation de murs d'isolement verticaux 29 décrite en relation avec la figure 2D.

A l'étape illustrée en figure 3H, on a d'abord formé une première couche d'oxyde 35 d'une épaisseur de l'ordre de 1 µm dans laquelle on a formé une ouverture à l'emplacement où l'on veut former le mur. On a ensuite déposé une deuxième couche d'oxyde 36 d'épaisseur inférieure à celle de la première couche d'oxyde, par exemple de l'ordre de 200 à 300 nm.

A l'étape illustrée en figure 3I, on a gravé une ouverture d'une largeur de, par exemple, 2 µm dans la deuxième couche d'oxyde 36 au fond de l'ouverture ménagée dans la première couche d'oxyde 35 ; on a gravé par gravure sèche le silicium monocristallin 25 selon le contour du mur ; et on a enlevé la résine qui a servi à définir l'ouverture dans la partie interne de la couche 36. Une désoxydation partielle permet ensuite de retirer la casquette d'oxyde due à la légère surgravure du silicium 25 sous l'oxyde 36.

A l'étape représentée en figure 3J, on a procédé successivement à la croissance d'une couche d'oxyde 37 pour isoler les parois latérales de l'ouverture correspondant au mur d'isolement, puis au dépôt d'une couche de remplissage de silicium polycristallin 38 pour combler l'ouverture.

Enfin, comme cela est représenté en figure 3K, on élimine la couche de silicium polycristallin 38 par planarisation mécanochimique poursuivie jusqu'au niveau du silicium monocristallin. On obtient ainsi une structure comprenant des zones distinctes de silicium monocristallin, les unes correspondant aux régions 24 dans lesquelles on trouve du silicium monocristallin non perturbé d'une face à l'autre de la structure, les autres correspondant aux régions 25 formant des caissons complètement isolés par rapport au substrat 10. La zone perturbée 27 se trouve au voisinage immédiat du mur d'isolement et n'est pas susceptible de perturber les composants qui seront formés dans le caisson isolé 25 ou dans l'ensemble du substrat 10 et de la couche épitaxiée 24.

La figure 4 illustre un exemple de structure que l'on peut obtenir par le procédé selon la présente invention. Dans l'exemple de la figure 4, le substrat 10 de départ est une région 41 faiblement dopée de type N dont la face inférieure comprend une région 42 fortement dopée de type P et la couche épitaxiée est une région faiblement dopée de type N 24-25. Dans la couche épitaxiée 24, on a formé successivement une région de type P 43 et une région de type N 44 pour obtenir une structure de thyristor vertical constituée des régions 44, 43, 24-41, 42. Avec ce type de structure de puissance, on pourra former simplement dans le caisson 25 des composants de type bipolaire. On pourra préférer que la couche de silicium 12 à partir de laquelle a été développé le caisson 25 ait été fortement dopée de type N⁺ pour qu'il existe une semelle fortement dopée de type N⁺ au fond du caisson, cette semelle correspondant par exemple à des zones de contact de collecteur de transistors NPN.

La figure 5 représente un autre exemple de structure selon la présente invention constituée à partir du même substrat N-P 41-42 que celui de la figure 4. Sur ce substrat, on développe une épitaxie 24 de type P à l'intérieur de laquelle on forme une région 54 de type N. On obtient ainsi un thyristor vertical comprenant les couches 42, 41, 24 et 54. On notera que dans ce cas le substrat du caisson logique 25 est de type P alors qu'il était de type N dans le cas de la figure 4.

Dans l'exemple de la figure 6, le substrat est fortement dopé de type N⁺ et la couche épitaxiée est de type N. Dans la couche 24, on forme des cellules 61 de transistors DMOS verticaux. Dans ce cas, il sera simple de former dans le caisson 25 des transistors MOS complémentaires. Comme dans le cas de la figure 4, on pourra préférer qu'il existe une semelle de type N⁺ au fond du caisson.

Les figures 4 et 6 illustrent seulement des exemples d'application de la présente invention. De nombreuses autres structures de puissance pourront être réalisées en combinaison avec des circuits logiques incluant des transistors bipolaires, des transistors MOS ou les deux. Plusieurs caissons isolés destinés à contenir des circuits logiques pourront être formés en divers emplacements superficiels d'un même substrat.

Bien entendu, la présente invention est susceptible de diverses variantes et modifications qui apparaîtront à l'homme de l'art. En particulier, les matériaux des diverses couches décrites précédemment pourront être modifiés selon la filière technologique choisie du moment que les couches obtenues atteignent la fonction recherchée, c'est-à-dire, par exemple constituer une couche de masquage gravable sélectivement par rapport au silicium pour les couches 11, 31, 35 et 36, ou constituer une couche de remplissage facile à rendre plane pour la couche 38. De plus, le type de conductivité et le niveau de dopage de la couche mince de silicium monocristallin 12 pourront être librement choisis en relation avec le type de conductivité et le niveau de dopage de la couche épitaxiée du caisson 25 pour former, si on le souhaite, une semelle d'un type particulier au fond du caisson.

## Revendications

1. Procédé de formation d'un caisson isolé dans une portion supérieure d'un substrat de silicium, caractérisé en ce qu'il comprend les étapes suivantes :
prévoir une structure de type silicium sur isolant comprenant un substrat de silicium (10), une couche isolante (11) et une couche mince de silicium monocristallin (12) ;
éliminer la couche isolante et la couche mince de silicium en dehors des emplacements où l'on veut former le caisson isolé ;
faire croître une couche épitaxiée (24, 25) sur toute la surface supérieure de la structure, pour servir de couche active des caissons et de couche supérieure des composants de puissance en dehors de la région occupée par le caisson ;
effectuer une planarisation ; et
réaliser un mur d'isolement vertical (29) à l'aplomb de la périphérie de la portion maintenue (21) de la couche mince isolante.

2. Procédé selon la revendication 1, caractérisé en ce que l'étape de gravure de la couche mince de silicium monocristallin (12) et de la couche isolante (11) comprend les étapes suivantes :
former une couche d'un premier matériau (31) gravable sélectivement par rapport au silicium ;
déposer et délimiter un masque de résine photosensible (32) ;
graver la couche du premier matériau (31) et la couche mince de silicium (12) ;
déposer une nouvelle couche de résine (33) présentant un débordement (d) par rapport aux couches déjà gravées ;
graver la couche isolante (11) sous la nouvelle couche de résine ;
éliminer la couche de résine et la partie supérieure restante de la couche du premier matériau.

3. Procédé selon la revendication 1, caractérisé en ce que la couche épitaxiée a une épaisseur supérieure à 10 µm.

4. Procédé selon la revendication 3, caractérisé en ce que l'épaisseur de la couche épitaxiée est de l'ordre de 40 à 60 µm.

5. Procédé selon la revendication 4, caractérisé en ce que la couche isolante et la couche du premier matériau sont des couches d'oxyde de silicium.

6. Procédé selon la revendication 1, caractérisé en ce que la formation du mur d'isolement vertical comprend les étapes suivantes :
former une couche (35) d'un deuxième matériau d'une première épaisseur ;
former dans la couche du deuxième matériau une première ouverture à l'emplacement du mur que l'on souhaite former ;
former une couche d'un troisième matériau d'une deuxième épaisseur ;
graver la couche du deuxième matériau sensiblement au milieu de la première ouverture ;
ouvrir le silicium sous-jacent jusqu'à la couche d'oxyde d'isolement de fond (21) ;
procéder à la formation d'un isolement sur les parois de l'ouverture ;
procéder à un remplissage de silicium polycristallin.

7. Procédé selon la revendication 6, caractérisé en ce que les deuxième et troisième matériaux sont de l'oxyde de silicium et la deuxième épaisseur est inférieure à la première épaisseur.

8. Procédé selon la revendication 1, caractérisé en ce que la couche mince de silicium monocristallin (12) est fortement dopée d'un type de conductivité choisi, la couche épitaxiée étant du même type de conductivité à faible niveau de dopage.
